# FASCICULE DE BREVET EUROPEEN

(11) **EP 4 360 411 B1**
(45) Date de publication et mention de la délivrance du brevet: **08.04.2026**
(21) Numéro de dépôt: 22737779.3
(22) Date de dépôt: 20.06.2022
(51) Int. Cl.: H05K 7/14

(54) **UNITÉ ÉLECTRONIQUE POUR CONVERTISSEUR DE TENSION DE MACHINE ÉLECTRIQUE TOURNANTE**
ELEKTRONIKEINHEIT FÜR EINEN SPANNUNGSWANDLER EINER ROTIERENDEN ELEKTRISCHEN MASCHINE
ELECTRONIC UNIT FOR A VOLTAGE CONVERTER OF A ROTATING ELECTRIC MACHINE

(30) Priorité: 23.06.2021 FR 2106718
(43) Date de publication de la demande: 01.05.2024
(73) Titulaire: Valeo Electrification, 95800 Cergy (FR)
(72) Inventeur: FALGUIER, Manuel, 94046 Créteil Cedex (FR); RICHE, Christopher, 94046 Créteil Cedex (FR); MERCIER, Philippe, 72300 Sable Sur Sarthe (FR)
(74) Mandataire: Valeo Powertrain Systems
(86) Numéro de dépôt international: PCT/EP2022/066672
(87) Numéro de publication internationale: WO 2022/268681

(56) Documents cités:
- EP-A1- 2 643 919
- EP-B1- 2 643 919
- FR-A1- 3 093 889
- US-A1- 2009 237 905

## Description

L'invention porte sur une unité électronique pour convertisseur de tension de machine électrique tournante. L'invention porte également sur un convertisseur de tension équipé d'une telle unité électronique ainsi que sur un ensemble électrique comprenant un tel convertisseur de tension et une machine électrique tournante.

Il est connu du document FR3093889 A1 une unité électronique pour convertisseur de tension de machine électrique tournante comprenant :
- une première barre omnibus comprenant :
   - une première plaque,
   - une première portion de connexion se projetant à partir de la première plaque, d'un premier côté de la première plaque, perpendiculairement à la première plaque, la première portion de connexion comprenant une première surface de connexion apte à être soudée à une deuxième surface de connexion, faisant face à la première surface de connexion, d'une troisième barre omnibus d'un module électronique de puissance par soudure laser à l'aide d'un faisceau laser passant à l'interface entre la première surface de connexion et la deuxième surface de connexion,
- une deuxième barre omnibus distincte de la première barre omnibus et comprenant une deuxième plaque parallèle à la première plaque et située d'un deuxième côté de la première plaque opposé au premier côté,
- un boitier isolant électriquement la première barre omnibus de la deuxième barre omnibus,
- un couvercle métallique apte à bloquer le faisceau laser.

Une telle unité électronique répond au besoin de blocage du faisceau laser lors de la soudure des première surface de connexion et deuxième surface de connexion. Cependant une telle unité électronique est complexe et nécessite l'utilisation d'un couvercle pouvant entrainer l'utilisation de joints d'étanchéité.

La présente invention vise à résoudre tout ou partie de ces inconvénients.

Le document EP2643919A1 présente une machine électrique tournante dans laquelle des circuits électroniques sont soudés à des barres omnibus grâce à une soudure Laser.

Le document US20090237905A1 présente une machine électrique tournante dans laquelle des barres omnibus sont soudées.

L'invention porte sur une unité électronique pour convertisseur de tension de machine électrique tournante comprenant :
- une première barre omnibus comprenant :
   - une première plaque,
   - une première portion de connexion se projetant à partir de la première plaque, d'un premier côté de la première plaque, la première portion de connexion comprenant une première surface de connexion, la première surface de connexion formant un premier angle avec la première plaque, la première surface de connexion étant apte à être soudée à une deuxième surface de connexion, faisant face et étant parallèle à la première surface de connexion, d'une troisième barre omnibus d'un module électronique de puissance par une première soudure laser à l'aide d'un premier faisceau laser passant à une première interface entre la première surface de connexion et la deuxième surface de connexion,
- une deuxième barre omnibus distincte de la première barre omnibus et comprenant une deuxième plaque parallèle à la première plaque et située d'un deuxième côté de la première plaque opposé au premier côté,
- un premier boitier isolant électriquement la première barre omnibus de la deuxième barre omnibus,

dans laquelle la première barre omnibus ou la deuxième barre omnibus comprend une première extension s'étendant au droit de la première surface de connexion, la première extension étant apte à bloquer le premier faisceau laser, et
dans laquelle le premier boitier comprend une première zone libre au droit de la première surface de connexion, la première zone libre étant apte à laisser apparente la première extension pour le premier faisceau laser.

L'utilisation d'une telle première extension permet de bloquer le premier faisceau laser sans ajouter de capot complexe, en particulier nécessitant une étanchéité, pour réaliser cette fonction de blocage du premier faisceau laser. La réalisation d'une telle unité électronique est donc plus facile à fabriquer et a un coût réduit. De plus la réalisation de la première zone libre permet de ne pas interrompre le premier faisceau laser avant son blocage par la première extension. On limite ainsi une dégradation du premier boitier lors de la première soudure laser. Les fumées et projections de matière dégradée du premier boitier lors de la première soudure laser sont réduites ou évitées. On peut ainsi éviter l'utilisation de couteux dispositifs de traitement de fumée. On peut aussi éviter une opération de nettoyage après la réalisation de la première soudure laser. Par conséquent, le coût de fabrication de l'unité électronique est réduit.

Selon une caractéristique supplémentaire de l'invention, la première extension est perpendiculaire à la première surface de connexion.

Une telle orientation pour la première extension par rapport à la première surface de connexion permet d'éviter que la réflexion du premier faisceau laser atteigne des parties environnantes de l'unité électronique, notamment le premier boitier, ainsi que d'autres éléments situés autour de l'unité électronique.

Selon une caractéristique supplémentaire de l'invention, la première extension s'étend de plus de 0,5mm, notamment de plus de 1mm, par rapport à la projection de la première surface de connexion sur la première extension dans une direction perpendiculaire à la première extension. Une telle longueur pour la première extension participe à améliorer le blocage du faisceau laser par la première extension.

Selon une caractéristique supplémentaire de l'invention, la première portion de connexion est issue de matière avec la première plaque.

Une telle première portion de connexion permet de simplifier la fabrication de la première barre omnibus. La première barre omnibus est par exemple formée par pliage. Le coût de la première barre omnibus peut ainsi être réduit.

Selon une caractéristique supplémentaire de l'invention, la première extension est issue de matière avec la deuxième plaque.

Une telle première extension ne nécessite pas de pièce additionnelle pour bloquer le premier faisceau laser. Elle permet donc une simplification et une réduction du coût de l'unité électronique. Selon une caractéristique supplémentaire de l'invention la première extension est une troisième plaque fixée directement à la première plaque.

La fixation directe est par exemple une soudure, une brasure ou un clinchage. L'utilisation d'un paillon de brasure entre la première plaque et la première extension pour une fixation par brasure est considéré, au sens de l'invention, comme une fixation directe.

Selon une caractéristique supplémentaire de l'invention, la deuxième barre omnibus comprend une deuxième portion de connexion se projetant à partir de la deuxième plaque, d'un premier côté de la deuxième plaque, la deuxième portion de connexion comprenant une troisième surface de connexion, la troisième surface de connexion formant un deuxième angle avec la deuxième plaque, la troisième surface de connexion étant apte à être soudée à une quatrième surface de connexion, faisant face et étant parallèle à la troisième surface de connexion, d'une quatrième barre omnibus d'un module électronique de puissance par une deuxième soudure laser à l'aide d'un deuxième faisceau laser passant à une deuxième interface entre la troisième surface de connexion et la quatrième surface de connexion,
la deuxième barre omnibus comprenant une deuxième extension s'étendant au droit de la troisième surface de connexion, la deuxième extension étant apte à bloquer le deuxième faisceau laser,
la deuxième extension étant une quatrième plaque fixée directement à la deuxième plaque, et dans laquelle le premier boitier comprend une deuxième zone libre au droit de la troisième surface de connexion, la deuxième zone libre étant apte à laisser apparente la deuxième extension pour le deuxième faisceau laser.

L'utilisation d'une telle deuxième extension permet de bloquer le deuxième faisceau laser sans ajouter de capot complexe, en particulier nécessitant une étanchéité, pour réaliser cette fonction de blocage du premier faisceau laser. La réalisation d'une telle unité électronique est donc plus facile à fabriquer et a un coût réduit. De plus la réalisation de la deuxième zone libre permet de ne pas interrompre le deuxième faisceau laser avant son blocage par la deuxième extension. On limite ainsi une dégradation du premier boitier lors de la deuxième soudure laser. Les fumées et projections de matière dégradée du premier boitier lors de la deuxième soudure laser sont réduites ou évitées. On peut ainsi éviter l'utilisation de couteux dispositifs de traitement de fumée. On peut aussi éviter une opération de nettoyage après la réalisation de la deuxième soudure laser. Par conséquent, le coût de fabrication de l'unité électronique est réduit.

Selon une caractéristique supplémentaire de l'invention la quatrième plaque a la même épaisseur que la première plaque ou la même épaisseur que la deuxième plaque.

Une telle quatrième plaque peut permettre la réalisation de la quatrième plaque dans une chute de la première plaque ou une chute de la deuxième plaque. Le coût de la matière nécessaire à la réalisation de la quatrième plaque est ainsi réduit.

Selon une caractéristique supplémentaire de l'invention, le premier boitier est surmoulé sur la première barre omnibus et la deuxième barre omnibus.

L'utilisation d'un surmoulage permet de réduire le nombre de pièces de l'unité électronique et donc peut permettre une réduction de son coût.

Selon une caractéristique supplémentaire de l'invention, l'unité électronique pour convertisseur de tension de machine électrique tournante comprend un condensateur dont une première borne est connectée électriquement directement à la première barre omnibus notamment par soudage, brasage ou sertissage, et une deuxième borne est connectée électriquement directement à la deuxième barre omnibus notamment par soudage, brasage ou sertissage.

L'utilisation d'un condensateur permet un filtrage de l'alimentation électrique d'un module électronique de puissance.

Selon une caractéristique supplémentaire de l'invention, le premier boitier comprend un muret formant une cheminée entourant la première borne et la deuxième borne, la cheminée étant apte à recevoir une résine de protection de manière à protéger la connexion électrique entre la première barre omnibus et la première borne et la connexion électrique entre la deuxième barre omnibus et la deuxième borne.

L'utilisation d'un tel muret permet la protection des connexions électriques du condensateur avec une résine sans qu'il soit nécessaire d'ajouter une pièce faisant rebord. Le nombre de pièces de l'unité électronique est réduit ce qui peut permettre également une réduction du coût de l'unité électronique.

Selon une caractéristique supplémentaire de l'invention, le premier angle a une valeur égale à 90°. Selon une caractéristique supplémentaire de l'invention, le deuxième angle a une valeur égale à 90°.

L'invention porte également sur un convertisseur de tension de machine électrique tournante comprenant une unité électronique telle que décrite précédemment et un module électronique de puissance apte à alimenter électriquement un bobinage de machine électrique tournante.

Selon une caractéristique supplémentaire de l'invention, le module électronique de puissance comprend un deuxième boitier, le deuxième boitier étant surmoulé sur la troisième barre omnibus et la quatrième barre omnibus.

Selon une caractéristique supplémentaire de l'invention la première barre omnibus est une barre omnibus négative et la deuxième barre omnibus est une barre omnibus positive.

Selon une caractéristique supplémentaire de l'invention le module électronique de puissance comprend une troisième barre omnibus et une quatrième barre omnibus, la première barre omnibus étant soudée par une première soudure laser avec la troisième barre omnibus et la deuxième barre omnibus étant soudée par une deuxième soudure laser avec la quatrième barre omnibus.

L'invention porte également sur un ensemble électrique comprenant un convertisseur de tension tel que décrit précédemment et une machine électrique tournante.

Dans tout ce qui précède, l'ensemble électrique peut avoir à la fois une fonction d'alternateur et de moteur électrique. Ainsi, en fonctionnement comme alternateur, l'ensemble électrique fournit de l'énergie électrique en direction de la source d'alimentation électrique à partir de la rotation d'un arbre de sortie de la machine électrique tournante. Le convertisseur de tension fonctionne alors comme redresseur. En fonctionnement comme moteur électrique, la machine électrique tournante 130 entraîne l'arbre de sortie. Le convertisseur de tension fonctionne alors comme onduleur.

La machine électrique tournante peut comprendre, sur l'arbre de sortie, une poulie ou tout autre moyen de liaison vers le reste d'un groupe motopropulseur du véhicule. La machine électrique tournante est par exemple reliée, notamment via une courroie, au vilebrequin d'un moteur thermique du véhicule. En variante, la machine électrique est reliée à d'autres emplacement du groupe motopropulseur, par exemple à l'entrée de la boîte de vitesses du point de vue du couple transitant vers les roues du véhicule, en sortie de la boîte de vitesses du point de vue du couple transitant vers les roues du véhicule, au niveau de la boîte de vitesses du point de vue du couple transitant vers les roues du véhicule, ou encore sur le train avant ou le train arrière de ce groupe motopropulseur.

La machine électrique tournante peut comprendre un rotor comprenant un nombre de paires de pôles quelconque, par exemple six ou huit paires de pôles. La machine électrique tournante peut avoir un stator ayant un bobinage électrique polyphasé, par exemple formé par des fils ou par des barres conductrices reliées les unes les autres.

L'invention pourra être mieux comprise à la lecture de la description qui va suivre d'exemples non limitatifs de mise en œuvre de celle-ci et à l'examen du dessin annexé sur lequel :
- la figure 1 représente un schéma électrique d'un ensemble électrique comprenant une unité électronique selon l'invention,
- la figure 2 représente une vue schématique d'une unité électronique selon l'invention,
- la figure 3 représente une vue schématique partielle de l'unité électronique de la figure 2,
- la figure 4 représente une autre vue schématique partielle de l'unité électronique de la figure 2,
- la figure 5 représente une vue schématique en coupe d'un convertisseur de tension comprenant l'unité électronique de la figure 2,
- la figure 6 représente une autre vue schématique en coupe du convertisseur de tension de la figure 5,
- la figure 7 représente une autre vue schématique partielle de l'unité électronique de la figure 2,
- la figure 8 représente une vue schématique partielle du convertisseur de tension de la figure 5,
- la figure 9 représente une autre vue schématique partielle du convertisseur de tension de la figure 5.

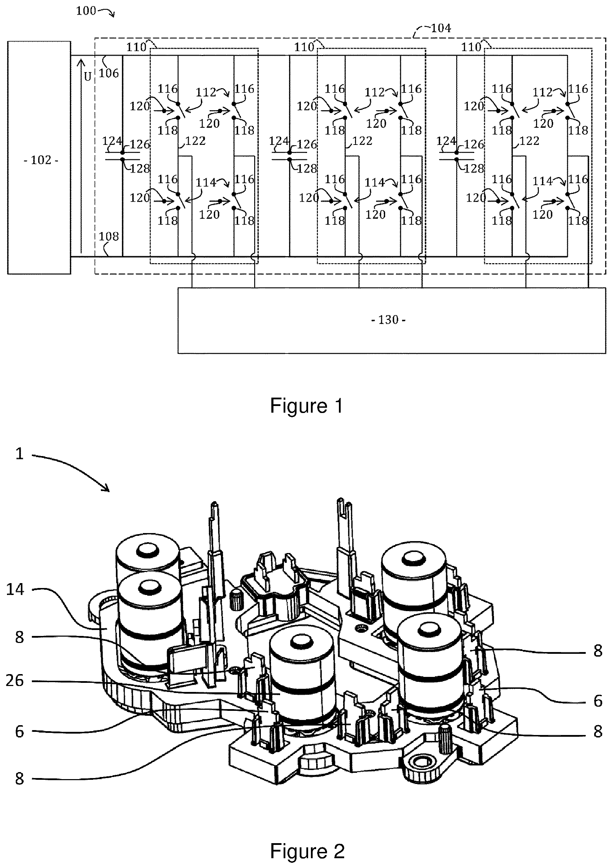

Sur toutes les figures, les éléments identiques ou assurant la même fonction portent les mêmes numéros de référence. Les réalisations suivantes sont des exemples. Bien que la description se réfère à un ou plusieurs modes de réalisation, ceci ne signifie pas nécessairement que chaque référence concerne le même mode de réalisation ou que les caractéristiques s'appliquent seulement à un seul mode de réalisation. De simples caractéristiques de différents modes de réalisation peuvent également être combinées ou interchangées pour fournir d'autres réalisations. La figure 1 représente un ensemble électrique 100 dans lequel peut être mis en œuvre l'invention. L'ensemble électrique 100 est par exemple destiné à être implanté dans un véhicule automobile. L'ensemble électrique 100 comporte tout d'abord une source d'alimentation électrique 102 conçue pour fournir une tension continue U, par exemple comprise entre 20 V et 100 V, par exemple 48 V. La source d'alimentation électrique 102 comporte par exemple une batterie.

L'ensemble électrique 100 comporte en outre une machine électrique tournante 130 comportant plusieurs enroulements de phase (non représentés) destinées à présenter des tensions de phase respectives.

L'ensemble électrique 100 comporte en outre un système électronique 104.

Dans les différents modes de réalisation représentés sur les figures le système électronique 104 est un convertisseur de tension 104. Cependant dans d'autres modes de réalisation non représentés l'ensemble peut assurer une fonction différente.

Le convertisseur de tension 104 est connecté entre la source d'alimentation électrique 102 et la machine électrique tournante 130 pour effectuer une conversion entre la tension continue U et les tensions de phase.

Le convertisseur de tension 104 comporte tout d'abord une ligne électrique positive 106 et une ligne électrique négative 108 destinées à être connectées à la source d'alimentation électrique 102 pour recevoir la tension continue U, la ligne électrique positive 106 recevant un potentiel électrique haut et la ligne électrique négative 108 recevant un potentiel électrique bas.

Le convertisseur de tension 104 comporte en outre au moins un module électronique de puissance 110 comportant une ou plusieurs lignes électriques de phase 122 destinées être respectivement connectées à une ou plusieurs phases de la machine électrique tournante 130, pour fournir leurs tensions de phase respectives.

Dans l'exemple décrit, le convertisseur de tension 104 comporte trois modules électroniques de puissance 110 comportant chacun deux lignes électriques de phase 122 connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières lignes électriques de phase 122 des modules électroniques de puissance 110 sont respectivement connectées aux trois phases du premier système triphasé, tandis que les deuxièmes lignes électriques de phase 122 des modules électroniques de puissance 110 sont respectivement connectées aux trois phases du deuxième système triphasé.

Chaque module électronique de puissance 110 comporte, pour chaque ligne électrique de phase 122, un premier interrupteur commandable 112 connecté entre la ligne électrique positive 106 et la ligne électrique de phase 122 et un deuxième interrupteur commandable 114 connecté entre la ligne électrique de phase 122 et la ligne électrique négative 108. Ainsi, les interrupteurs commandables 112, 114 sont agencés de manière à former un bras de hachage, dans lequel la ligne électrique de phase 122 forme un point milieu.

Chaque interrupteur commandable 112, 114 comporte des première et deuxième bornes principales 116, 118 et une borne de commande 120 destinée à sélectivement ouvrir et fermer l'interrupteur commandable 112, 114 entre ses deux bornes principales 116, 118 en fonction d'un signal de commande qui lui est appliqué. Les interrupteurs commandables 112, 114 sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118.

Dans l'exemple décrit, les interrupteurs commandables 112, 114 ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. En outre, la face inférieure forme une surface de dissipation thermique.

Le convertisseur de tension 104 comporte en outre, pour chaque module électronique de puissance 110, une capacité de filtrage 124 présentant une première borne 126 et une deuxième borne 128 respectivement connectées à la ligne électrique positive 106 et à la ligne électrique négative 108.

Il sera apprécié que la ligne électrique positive 106, la ligne électrique négative 108 et les lignes électriques de phase 122 sont des éléments rigides conçus pour supporter des courants électriques d'au moins 1 A. Elles présentent de préférence une épaisseur d'au moins 1 mm.

La figure 2 représente une vue schématique d'une unité électronique 1 pour convertisseur de tension 104 de machine électrique tournante 130 selon l'invention. L'unité électronique 1 comprend une première barre omnibus 8, une deuxième barre omnibus 6 distincte de la première barre omnibus 8 et un premier boitier 14 isolant électriquement la première barre omnibus 8 de la deuxième barre omnibus 6.

La première barre omnibus 8 est par exemple une barre omnibus négative. La première barre omnibus 8 est par exemple connectée électriquement à la ligne électrique négative 108. La deuxième barre omnibus 6 est par exemple une barre omnibus positive. La deuxième barre omnibus 6 est par exemple connectée électriquement à la ligne électrique positive 106. Le premier boitier 14 est par exemple surmoulé sur la première barre omnibus 8 et la deuxième barre omnibus 6.

Dans un autre mode de réalisation non représenté de l'invention, le premier boitier comprend un ensemble de parois isolantes, par exemple trois parois isolantes, assemblées ensemble notamment par clipsage.

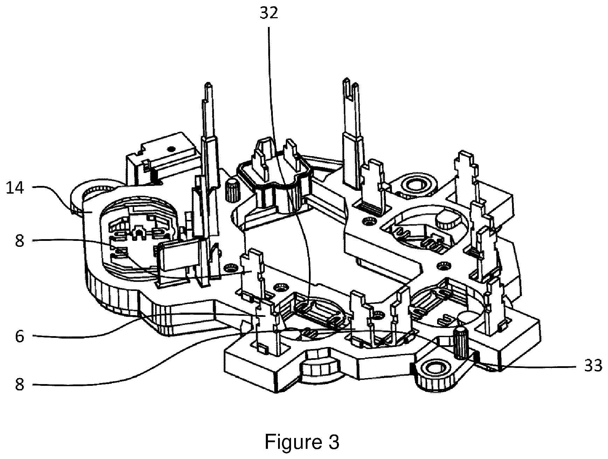

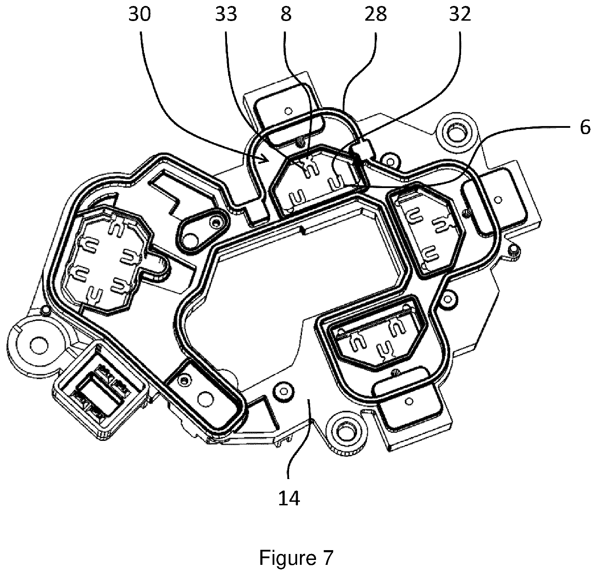

L'unité électronique 1 peut comprendre en outre un condensateur 26. Le condensateur est par exemple la capacité de filtrage 124. Le condensateur 26 peut comprendre une première borne 27 qui est connectée électriquement directement à la première barre omnibus 8. Dans le mode de réalisation représenté sur les figures, la première borne 27 est connectée électriquement à la première barre omnibus 8 par sertissage. Comme représenté sur la figure 3 et sur la figure 7, la première barre omnibus 8 peut comprendre une première fourche 32 comprenant deux branches entre lesquelles la première borne 27 est sertie. Dans le mode de réalisation de l'invention représenté sur les figures, l'unité électronique 1 comprend plusieurs condensateurs 26. Chacun des condensateurs comprend deux premières bornes 27 serties chacune dans une première fourche 32.

Dans un autre mode de réalisation de l'invention non représenté, la première borne 27 est connectée électriquement à la première barre omnibus par soudage ou brasage.

Le condensateur 26 peut comprendre une deuxième borne 28 qui est connectée électriquement directement à la deuxième barre omnibus 6. Dans le mode de réalisation représenté sur les figures la deuxième borne 28 est connectée électriquement à la deuxième barre omnibus 6 par sertissage. Comme représenté sur la figure 3, la deuxième barre omnibus 6 peut comprendre une deuxième fourche 33 comprenant deux branches entre lesquelles la deuxième borne 28 est sertie.

Dans un autre mode de réalisation de l'invention non représenté, la deuxième borne 28 est connectée électriquement à la deuxième barre omnibus par soudage ou brasage.

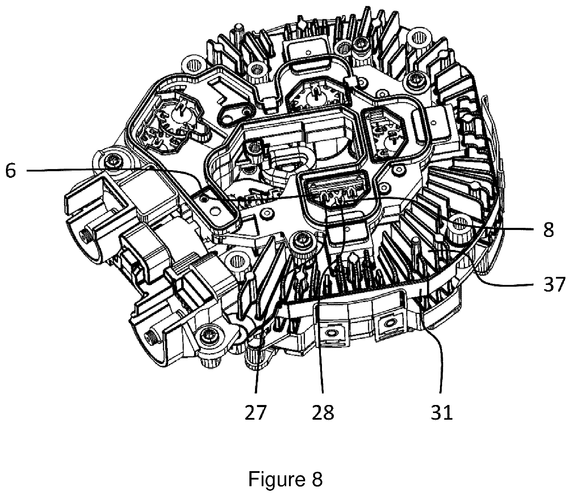

La figure 8 représente la connexion électrique par sertissage entre la première borne 27 et la première barre omnibus 8 et la connexion électrique par sertissage entre la deuxième borne 28 et la deuxième barre omnibus 6.

Le premier boitier 14 peut comprendre un muret 28 formant une cheminée 30 entourant la première borne 27 et la deuxième borne 28. La cheminée 30 peut recevoir une résine de protection 29 de manière à protéger la connexion électrique entre la première barre omnibus 8 et la première borne 27 et la connexion électrique entre la deuxième barre omnibus 6 et la deuxième borne 28. Dans le mode réalisation représenté sur les figures, la cheminée 30 peut recevoir une résine de protection 29 apte à protèger les premières bornes 27 et deuxième borne 28 d'une pluralité de condensateurs 26.

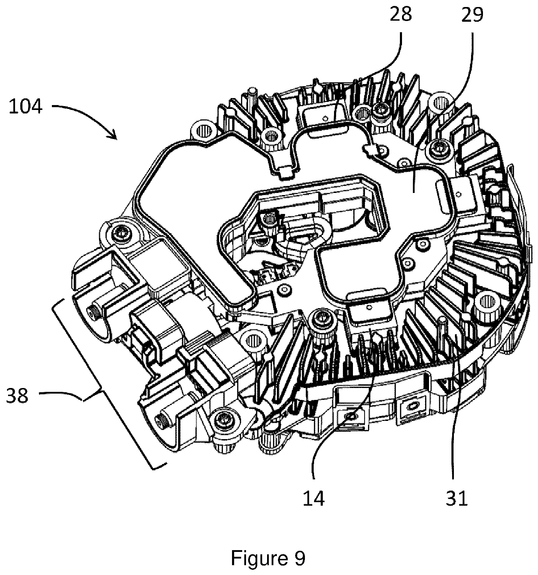

Dans un autre mode de réalisation de l'invention non représenté, chacun des condensateurs a sa propre cheminée pour protéger la connexion électrique entre la première barre omnibus et la première borne et la connexion électrique entre la deuxième barre omnibus et la deuxième borne. La figure 9 représente un convertisseur de courant 104 comprenant l'unité électronique dans laquelle de la résine 29 a été insérée dans la cheminée 30.

La figure 3 représente une vue schématique de la première barre omnibus 8 et de la deuxième barre omnibus 6.

La première barre omnibus 8 comprend une première plaque 2 et une première portion de connexion 3. La première portion de connexion 3 se projette à partir de la première plaque 2 d'un premier côté 4 de la première plaque 2. La première portion de connexion 3 comprend une première surface de connexion 5. La première surface de connexion 5 forme un premier angle 7 avec la première plaque 2.

Par exemple le premier angle 7 a une valeur égale à 90°.

La première portion de connexion 5 est par exemple issue de matière avec la première plaque 2 comme dans le mode de réalisation représenté sur les figures.

Dans un autre mode de réalisation non représenté, la première portion de connexion est rapportée, par exemple par soudage, brasage ou clinchage sur la première plaque.

La première surface de connexion 5 est apte à être soudée à une deuxième surface de connexion 9 d'une troisième barre omnibus 10 du module électronique de puissance 110. La deuxième surface de connexion 9 fait face et est parallèle à la première surface de connexion 5. La soudure entre la première surface de connexion5 et la deuxième surface de connexion 9 est une première soudure laser faite à l'aide d'un premier faisceau laser passant à une première interface 11 entre la première surface de connexion 5 et la deuxième surface de connexion 9. La première interface 11 est par exemple un premier espace entre la première surface de connexion 5 et la deuxième surface de connexion 9 suffisamment petit pour permettre la soudure avec le premier faisceau laser. Le premier espace a par exemple une épaisseur inférieure à 0,5mm. La première interface 11 peut également être un contact entre la première surface de connexion 5 et la deuxième surface de connexion 9.

La deuxième barre omnibus 6 comprend une deuxième plaque 12 parallèle à la première plaque 2 et située d'un deuxième côté 13 de la première plaque 2 opposé au premier côté 4.

La première barre omnibus 8 ou la deuxième barre omnibus 6 comprend une première extension 15 s'étendant au droit de la première surface de connexion 5. La première extension 15 est apte à bloquer le premier faisceau laser.

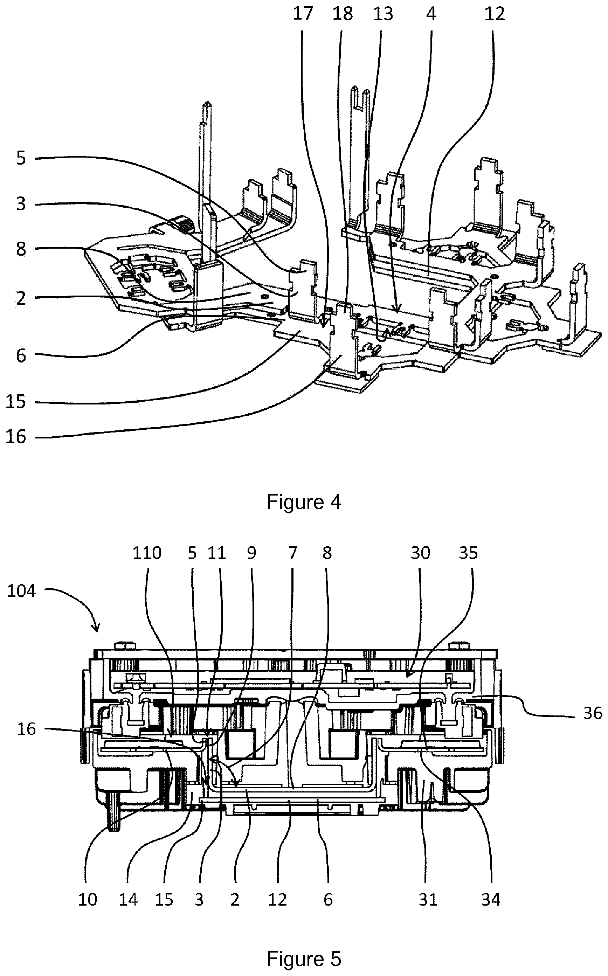

Dans le mode de réalisation représenté sur les figures la deuxième barre omnibus comprend la première extension 15. Par exemple la première extension 15 est issue de matière avec la deuxième plaque 12. Une telle première extension 15 est en particulier visible sur la figure 4 et la figure 5.

Dans un autre mode de réalisation non représenté, la première barre omnibus comprend la première extension. La première extension 15 est par exemple une troisième plaque fixée directement à la première plaque 2. La fixation directe est par exemple une soudure, une brasure ou un clinchage.

La première extension 15 est par exemple perpendiculaire à la première surface de connexion 5. La première extension 15 s'étend par exemple de plus de 0,5mm, notamment de plus de 1mm, par rapport à la projection de la première surface de connexion 5 sur la première extension 15 dans une direction perpendiculaire à la première extension 15.

Le premier boitier 14 comprend une première zone libre 16 au droit de la première surface de connexion 5. La première zone libre 16 est apte à laisser apparente la première extension 15 pour le premier faisceau laser. En d'autre terme, le premier boitier 14 ne bloque pas le premier faisceau laser.

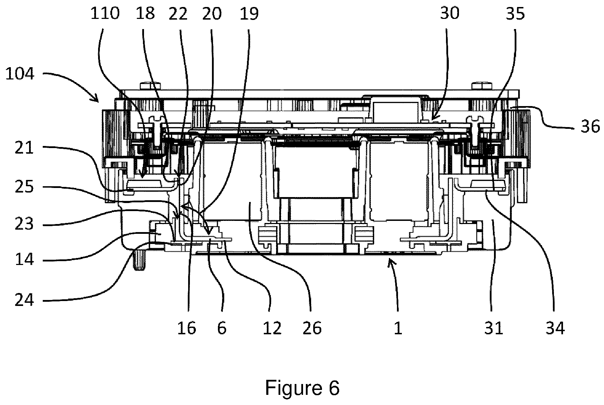

Comme c'est visible sur la figure 4 et la figure 6, la deuxième barre omnibus 6 peut comprendre une deuxième portion de connexion 16 se projetant à partir de la deuxième plaque d'un premier côté 17 de la deuxième plaque 12. La deuxième portion de connexion 16 peut comprendre une troisième surface de connexion 18. La troisième surface de connexion 18 peut former un deuxième angle 19 avec la deuxième plaque 12. Par exemple le deuxième angle 19 a une valeur égale à 90°. La troisième surface de connexion 18 est par exemple apte à être soudée à une quatrième surface de connexion 20 d'une quatrième barre omnibus 21 du module électronique de puissance 110. La troisième surface de connexion peut faire face et être parallèle à la troisième surface de connexion 18. La soudure entre la troisième surface de connexion 18 et la quatrième surface de connexion 20 est par exemple une deuxième soudure laser à l'aide d'un deuxième faisceau laser passant à une deuxième interface 22 entre la troisième surface de connexion 18 et la quatrième surface de connexion 20.

La deuxième interface 22 est par exemple un deuxième espace entre la troisième surface de connexion 18 et la quatrième surface de connexion 20 suffisamment petit pour permettre la soudure avec le deuxième faisceau laser. Le deuxième espace a par exemple une épaisseur inférieure à 0,5mm. La deuxième interface 22 peut également être un contact entre la troisième surface de connexion 18 et la quatrième surface de connexion 20.

La deuxième barre omnibus 6 peut comprendre une deuxième extension 23 s'étendant au droit de la troisième surface de connexion 18. La deuxième extension 23 peut être apte à bloquer le deuxième faisceau laser.

La deuxième extension 23 est par exemple une quatrième plaque 24 fixée directement à la deuxième plaque 12. La fixation directe est par exemple une soudure, une brasure ou un clinchage. La deuxième extension 23 est par exemple perpendiculaire à la troisième surface de connexion 18.

La deuxième extension 23 s'étend par exemple de plus de 0,5mm, notamment de plus de 1mm, par rapport à la projection de la troisième surface de connexion 18 sur la deuxième extension 23 dans une direction perpendiculaire à la deuxième extension 23.

La deuxième extension 23 a par exemple la même épaisseur que la première plaque 2 ou la même épaisseur que la deuxième plaque 12.

Le premier boitier 14 peut comprendre une deuxième zone libre 25 au droit de la troisième surface de connexion 18. La deuxième zone libre 25 est apte à laisser apparente la deuxième extension 23 pour le deuxième faisceau laser. En d'autre terme, le premier boitier 14 ne bloque pas le deuxième faisceau laser.

La première plaque 2, la deuxième plaque 12, la première portion de connexion 3, la deuxième portion de connexion 16, la première extension 15 et la deuxième extension 23 sont par exemple en métal, notamment en cuivre ou dans un alliage de cuivre.

Le module électronique de puissance 110 comprenant la troisième barre omnibus 10 et la quatrième barre omnibus 21 peut comprendre en outre un deuxième boitier. Le deuxième boitier est par exemple surmoulé sur la troisième barre omnibus 10 et la quatrième barre omnibus 21.

Le convertisseur de tension 104 peut comprendre un dissipateur thermique 31. Le module électronique de puissance 110 peut présenter une surface de dissipation thermique 34. La surface de dissipation thermique 34 du module électronique de puissance 110 peut être en contact thermique avec une surface d'échange thermique 35 du dissipateur thermique 31. Le contact thermique est par exemple réalisé par l'intermédiaire d'une pate thermique. Le dissipateur thermique 31 comprend par exemple des ailettes de refroidissement 37.

Dans un autre mode de réalisation de l'invention non représenté, le dissipateur thermique comprend un circuit de refroidissement pour un fluide de refroidissement.

Le convertisseur de tension 104 peut comprendre en outre un module électronique de commande 30 destiné à générer le signal de commande appliqué à la borne de commande 120. Le module électronique de commande 30 est par exemple monté dans un carter 36 monté sur le premier dissipateur thermique 31.

Le convertisseur de tension 104 peut comprendre un bornier 38 destiné à être connecté à la source d'alimentation 102. Le bornier 38 peut comprendre deux bornes connectées électriquement à la ligne électrique positive 106 et à la ligne électrique négative 108.

## Revendications

1. Unité électronique (1) pour convertisseur de tension (104) de machine électrique tournante (130) comprenant :
- une première barre omnibus (8) comprenant :
- une première plaque (2),
- une première portion de connexion (3) se projetant à partir de la première plaque, d'un premier côté (4) de la première plaque (2), la première portion de connexion (3) comprenant une première surface de connexion (5), la première surface de connexion (5) formant un premier angle (7) avec la première plaque (2), la première surface de connexion (5) étant apte à être soudée à une deuxième surface de connexion (9), faisant face et étant parallèle à la première surface de connexion (5), d'une troisième barre omnibus (10) d'un module électronique de puissance (110) par une première soudure laser à l'aide d'un premier faisceau laser passant à une première interface (11) entre la première surface de connexion (5) et la deuxième surface de connexion (9),
- une deuxième barre omnibus (6) distincte de la première barre omnibus (8) et comprenant une deuxième plaque (12) parallèle à la première plaque (2) et située d'un deuxième côté (13) de la première plaque (2) opposé au premier côté (4),
- un premier boitier (14) isolant électriquement la première barre omnibus (8) de la deuxième barre omnibus (6),
dans laquelle la première barre omnibus (8) ou la deuxième barre omnibus (6) comprend une première extension (15) s'étendant au droit de la première surface de connexion (5), la première extension (15) étant apte à bloquer le premier faisceau laser, et
dans laquelle le premier boitier (14) comprend une première zone libre (16) au droit de la première surface de connexion (5), la première zone libre (16) étant apte à laisser apparente la première extension (15) pour le premier faisceau laser.

2. Unité électronique (1) pour convertisseur de tension (104) de machine électrique tournante (130) selon la revendication précédente dans laquelle la première extension (15) est perpendiculaire à la première surface de connexion (5).

3. Unité électronique (1) pour convertisseur de tension (104) de machine électrique tournante (130) selon la revendication précédente dans laquelle la première extension (15) s'étend de plus de 0,5mm, notamment de plus de 1mm, par rapport à la projection de la première surface de connexion (5) sur la première extension (15) dans une direction perpendiculaire à la première extension (15).

4. Unité électronique (1) pour convertisseur de tension (104) de machine électrique tournante (130) selon la revendication précédente dans laquelle la première portion de connexion (3) est issue de matière avec la première plaque (2).

5. Unité électronique (1) pour convertisseur de tension (104) de machine électrique tournante (130) selon l'une des revendications précédentes dans laquelle la première extension (15) est issue de matière avec la deuxième plaque (12).

6. Unité électronique (1) pour convertisseur de tension (104) de machine électrique tournante (130) selon l'une des revendications 1 et 4 dans laquelle la première extension (15) est une troisième plaque fixée directement à la première plaque (2).

7. Unité électronique (1) pour convertisseur de tension (104) de machine électrique tournante (130) selon l'une des revendications précédentes dans lequel la deuxième barre omnibus (6) comprend une deuxième portion de connexion (16) se projetant à partir de la deuxième plaque, d'un premier côté (17) de la deuxième plaque (12), la deuxième portion de connexion (16) comprenant une troisième surface de connexion (18), la troisième surface de connexion (18) formant un deuxième angle (19) avec la deuxième plaque (12), la troisième surface de connexion (18) étant apte à être soudée à une quatrième surface de connexion (20), faisant face et étant parallèle à la troisième surface de connexion (18), d'une quatrième barre omnibus (21) d'un module électronique de puissance (110) par deuxième soudure laser à l'aide d'un deuxième faisceau laser passant à une deuxième interface (22) entre la troisième surface de connexion (18) et la quatrième surface de connexion (20),
la deuxième barre omnibus (6) comprenant une deuxième extension (23) s'étendant au droit de la troisième surface de connexion (18), la deuxième extension (23) étant apte à bloquer le deuxième faisceau laser,
la deuxième extension (23) étant une quatrième plaque (24) fixée directement à la deuxième plaque (12), et
dans laquelle le premier boitier (14) comprend une deuxième zone libre (25) au droit de la troisième surface de connexion (18), la deuxième zone libre (25) étant apte à laisser apparente la deuxième extension (23) pour le deuxième faisceau laser.

8. Unité électronique (1) pour convertisseur de tension (104) de machine électrique tournante (130) selon l'une des revendications précédentes dans laquelle le premier boitier (14) est surmoulé sur la première barre omnibus (8) et la deuxième barre omnibus (6).

9. Unité électronique (1) pour convertisseur de tension (104) de machine électrique tournante (130) selon l'une des revendications précédentes comprenant un condensateur (26) dont une première borne (27) est connectée électriquement directement à la première barre omnibus (8) notamment par soudage, brasage ou sertissage, et une deuxième borne (28) est connectée électriquement directement à la deuxième barre omnibus (6) notamment par soudage, brasage ou sertissage.

10. Unité électronique (1) pour convertisseur de tension (104) de machine électrique tournante (130) selon la revendication précédente dans lequel le premier boitier (14) comprend un muret (28) formant une cheminée (30) entourant la première borne et la deuxième borne, la cheminée (30) étant apte à recevoir une résine de protection (29) de manière à protéger la connexion électrique entre la première barre omnibus (8) et la première borne (27) et la connexion électrique entre la deuxième barre omnibus (6) et la deuxième borne (28).

11. Unité électronique (1) pour convertisseur de tension (104) de machine électrique tournante (130) selon l'une des revendications précédentes dans laquelle le premier angle (7) a une valeur égale à 90°.

12. Convertisseur de tension (104) de machine électrique tournante (130) comprenant une unité électronique (1) pour convertisseur de tension (104) de machine électrique tournante (130) selon l'une des revendications précédentes et un module électronique de puissance (110) apte à alimenter électriquement un bobinage de machine électrique tournante (130).

13. Convertisseur de tension (104) selon la revendication précédente dans lequel la première barre omnibus (8) est une barre omnibus négative et la deuxième barre omnibus (6) est une barre omnibus positive.

14. Convertisseur de tension (104) selon l'une des revendications 12 à 13 dans lequel le module électronique de puissance (110) comprend une troisième barre omnibus (10) et une quatrième barre omnibus (21), la première barre omnibus (8) étant soudée par une première soudure laser avec la troisième barre omnibus (10) et la deuxième barre omnibus (6) étant soudée par une deuxième soudure laser avec la quatrième barre omnibus (21).

15. Ensemble électrique (100) comprenant un convertisseur de tension (104) selon l'une des revendications 12 à 14 et une machine électrique tournante (130).

## Patentansprüche

1. Elektronische Einheit (1) für einen Spannungswandler (104) einer elektrischen Drehmaschine (130), umfassend:
- eine erste Sammelschiene (8), umfassend:
- eine erste Platte (2),
- einen ersten Verbindungsabschnitt (3), der von der ersten Platte aus einer ersten Seite (4) der ersten Platte (2) herausragt, wobei der erste Verbindungsabschnitt (3) eine erste Verbindungsfläche (5) umfasst, wobei die erste Verbindungsfläche (5) einen ersten Winkel (7) mit der ersten Platte (2) bildet, wobei die erste Verbindungsfläche (5) geeignet ist, mit einer zweiten Verbindungsfläche (9), die der ersten Verbindungsfläche (5) zugewandt und parallel zu dieser ist, einer dritten Sammelschiene (10) eines elektronischen Leistungsmoduls (110) durch eine erste Laserschweißung mittels eines ersten Laserstrahls, der durch eine erste Schnittstelle (11) zwischen der ersten Verbindungsfläche (5) und der zweiten Verbindungsfläche (9) verläuft, verschweißt zu werden,
- eine zweite Sammelschiene (6), die von der ersten Sammelschiene (8) getrennt ist und eine zweite Platte (12) umfasst, die parallel zur ersten Platte (2) ist und sich auf einer zweiten Seite (13) der ersten Platte (2) befindet, die der ersten Seite (4) gegenüberliegt,
- ein erstes Gehäuse (14), das die erste Sammelschiene (8) von der zweiten Sammelschiene (6) elektrisch isoliert,
wobei die erste Sammelschiene (8) oder die zweite Sammelschiene (6) eine erste Erweiterung (15) umfasst, die sich direkt über der ersten Verbindungsfläche (5) erstreckt, wobei die erste Erweiterung (15) geeignet ist, den ersten Laserstrahl zu blockieren, und
wobei das erste Gehäuse (14) einen ersten freien Bereich (16) direkt über der ersten Verbindungsfläche (5) umfasst, wobei der erste freie Bereich (16) geeignet ist, die erste Erweiterung (15) für den ersten Laserstrahl sichtbar zu lassen.

2. Elektronische Einheit (1) für einen Spannungswandler (104) einer elektrischen Drehmaschine (130) nach dem vorhergehenden Anspruch, wobei die erste Erweiterung (15) senkrecht zur ersten Verbindungsfläche (5) ist.

3. Elektronische Einheit (1) für einen Spannungswandler (104) einer elektrischen Drehmaschine (130) nach dem vorhergehenden Anspruch, wobei die erste Erweiterung (15) sich um mehr als 0,5 mm, insbesondere um mehr als 1 mm, in Bezug auf die Projektion der ersten Verbindungsfläche (5) auf die erste Erweiterung (15) in einer Richtung senkrecht zur ersten Erweiterung (15) erstreckt.

4. Elektronische Einheit (1) für einen Spannungswandler (104) einer elektrischen Drehmaschine (130) nach dem vorhergehenden Anspruch, wobei der erste Verbindungsabschnitt (3) aus dem Material der ersten Platte (2) besteht.

5. Elektronische Einheit (1) für einen Spannungswandler (104) einer elektrischen Drehmaschine (130) nach einem der vorhergehenden Ansprüche, wobei die erste Erweiterung (15) aus dem Material der zweiten Platte (12) besteht.

6. Elektronische Einheit (1) für einen Spannungswandler (104) einer elektrischen Drehmaschine (130) nach einem der Ansprüche 1 und 4, wobei die erste Erweiterung (15) eine dritte Platte ist, die direkt an der ersten Platte (2) befestigt ist.

7. Elektronische Einheit (1) für einen Spannungswandler (104) einer elektrischen Drehmaschine (130) nach einem der vorhergehenden Ansprüche, wobei die zweite Sammelschiene (6) einen zweiten Verbindungsabschnitt (16) umfasst, der von der zweiten Platte aus einer ersten Seite (17) der zweiten Platte (12) herausragt, wobei der zweite Verbindungsabschnitt (16) eine dritte Verbindungsfläche (18) umfasst, wobei die dritte Verbindungsfläche (18) einen zweiten Winkel (19) mit der zweiten Platte (12) bildet, wobei die dritte Verbindungsfläche (18) geeignet ist, mit einer vierten Verbindungsfläche (20), die der dritten Verbindungsfläche (18) zugewandt und parallel zu dieser ist, einer vierten Sammelschiene (21) eines elektronischen Leistungsmoduls (110) durch eine zweite Laserschweißung mittels eines zweiten Laserstrahls, der durch eine zweite Schnittstelle (22) zwischen der dritten Verbindungsfläche (18) und der vierten Verbindungsfläche (20) verläuft, verschweißt zu werden,
wobei die zweite Sammelschiene (6) eine zweite Erweiterung (23) umfasst, die sich direkt über der dritten Verbindungsfläche (18) erstreckt, wobei die zweite Erweiterung (23) geeignet ist, den zweiten Laserstrahl zu blockieren,
wobei die zweite Erweiterung (23) eine vierte Platte (24) ist, die direkt an der zweiten Platte (12) befestigt ist, und
wobei das erste Gehäuse (14) einen zweiten freien Bereich (25) direkt über der dritten Verbindungsfläche (18) umfasst, wobei der zweite freie Bereich (25) geeignet ist, die zweite Erweiterung (23) für den zweiten Laserstrahl sichtbar zu lassen.

8. Elektronische Einheit (1) für einen Spannungswandler (104) einer elektrischen Drehmaschine (130) nach einem der vorhergehenden Ansprüche, wobei das erste Gehäuse (14) auf die erste Sammelschiene (8) und die zweite Sammelschiene (6) umspritzt ist.

9. Elektronische Einheit (1) für einen Spannungswandler (104) einer elektrischen Drehmaschine (130) nach einem der vorhergehenden Ansprüche, umfassend einen Kondensator (26), dessen erste Klemme (27) elektrisch direkt mit der ersten Sammelschiene (8) verbunden ist, insbesondere durch Schweißen, Löten oder Crimpen, und dessen zweite Klemme (28) elektrisch direkt mit der zweiten Sammelschiene (6) verbunden ist, insbesondere durch Schweißen, Löten oder Crimpen.

10. Elektronische Einheit (1) für einen Spannungswandler (104) einer elektrischen Drehmaschine (130) nach dem vorhergehenden Anspruch, wobei das erste Gehäuse (14) eine Wand (28) umfasst, die einen Schacht (30) bildet, der die erste Klemme und die zweite Klemme umgibt, wobei der Schacht (30) geeignet ist, ein Schutzharz (29) aufzunehmen, um die elektrische Verbindung zwischen der ersten Sammelschiene (8) und der ersten Klemme (27) und die elektrische Verbindung zwischen der zweiten Sammelschiene (6) und der zweiten Klemme (28) zu schützen.

11. Elektronische Einheit (1) für einen Spannungswandler (104) einer elektrischen Drehmaschine (130) nach einem der vorhergehenden Ansprüche, wobei der erste Winkel (7) einen Wert von 90° hat.

12. Spannungswandler (104) einer elektrischen Drehmaschine (130), umfassend eine elektronische Einheit (1) für einen Spannungswandler (104) einer elektrischen Drehmaschine (130) nach einem der vorhergehenden Ansprüche und ein elektronisches Leistungsmodul (110), das geeignet ist, eine Wicklung einer elektrischen Drehmaschine (130) elektrisch zu versorgen.

13. Spannungswandler (104) nach dem vorhergehenden Anspruch, wobei die erste Sammelschiene (8) eine negative Sammelschiene und die zweite Sammelschiene (6) eine positive Sammelschiene ist.

14. Spannungswandler (104) nach einem der Ansprüche 12 bis 13, wobei das elektronische Leistungsmodul (110) eine dritte Sammelschiene (10) und eine vierte Sammelschiene (21) umfasst, wobei die erste Sammelschiene (8) durch eine erste Laserschweißung mit der dritten Sammelschiene (10) verschweißt ist und die zweite Sammelschiene (6) durch eine zweite Laserschweißung mit der vierten Sammelschiene (21) verschweißt ist.

15. Elektrische Anordnung (100), umfassend einen Spannungswandler (104) nach einem der Ansprüche 12 bis 14 und eine elektrische Drehmaschine (130).

## Claims

1. Electronic unit (1) for voltage converter (104) of rotating electrical machine (130) comprising:
- a first busbar (8) comprising:
- a first plate (2),
- a first connection portion (3) projecting from the first plate, from a first side (4) of the first plate (2), the first connection portion (3) comprising a first connection surface (5), the first connection surface (5) forming a first angle (7) with the first plate (2), the first connection surface (5) being suitable to be welded to a second connection surface (9), facing and being parallel to the first connection surface (5), of a third busbar (10) of a power electronic module (110) by a first laser weld using a first laser beam passing at a first interface (11) between the first connection surface (5) and the second connection surface (9),
- a second busbar (6) distinct from the first busbar (8) and comprising a second plate (12) parallel to the first plate (2) and located on a second side (13) of the first plate (2) opposite to the first side (4),
- a first housing (14) electrically insulating the first busbar (8) from the second busbar (6),
wherein the first busbar (8) or the second busbar (6) comprises a first extension (15) extending directly above the first connection surface (5), the first extension (15) being suitable to block the first laser beam, and
wherein the first housing (14) comprises a first free zone (16) directly above the first connection surface (5), the first free zone (16) being suitable to leave the first extension (15) exposed to the first laser beam.

2. Electronic unit (1) for voltage converter (104) of rotating electrical machine (130) according to the previous claim wherein the first extension (15) is perpendicular to the first connection surface (5).

3. Electronic unit (1) for voltage converter (104) of rotating electrical machine (130) according to the previous claim wherein the first extension (15) extends more than 0.5mm, particularly more than 1mm, relative to the projection of the first connection surface (5) onto the first extension (15) in a direction perpendicular to the first extension (15).

4. Electronic unit (1) for voltage converter (104) of rotating electrical machine (130) according to the previous claim wherein the first connection portion (3) is formed integrally with the first plate (2).

5. Electronic unit (1) for voltage converter (104) of rotating electrical machine (130) according to one of the previous claims wherein the first extension (15) is formed integrally with the second plate (12).

6. Electronic unit (1) for voltage converter (104) of rotating electrical machine (130) according to one of claims 1 and 4 wherein the first extension (15) is a third plate directly fixed to the first plate (2).

7. Electronic unit (1) for voltage converter (104) of rotating electrical machine (130) according to one of the previous claims wherein the second busbar (6) comprises a second connection portion (16) projecting from the second plate, from a first side (17) of the second plate (12), the second connection portion (16) comprising a third connection surface (18), the third connection surface (18) forming a second angle (19) with the second plate (12), the third connection surface (18) being suitable to be welded to a fourth connection surface (20), facing and being parallel to the third connection surface (18), of a fourth busbar (21) of a power electronic module (110) by second laser weld using a second laser beam passing at a second interface (22) between the third connection surface (18) and the fourth connection surface (20),
the second busbar (6) comprising a second extension (23) extending directly above the third connection surface (18), the second extension (23) being suitable to block the second laser beam,
the second extension (23) being a fourth plate (24) directly fixed to the second plate (12), and
wherein the first housing (14) comprises a second free zone (25) directly above the third connection surface (18), the second free zone (25) being suitable to leave the second extension (23) exposed to the second laser beam.

8. Electronic unit (1) for voltage converter (104) of rotating electrical machine (130) according to one of the previous claims wherein the first housing (14) is overmolded on the first busbar (8) and the second busbar (6).

9. Electronic unit (1) for voltage converter (104) of rotating electrical machine (130) according to one of the previous claims comprising a capacitor (26) whose first terminal (27) is electrically connected directly to the first busbar (8) particularly by welding, brazing or crimping, and a second terminal (28) is electrically connected directly to the second busbar (6) particularly by welding, brazing or crimping.

10. Electronic unit (1) for voltage converter (104) of rotating electrical machine (130) according to the previous claim wherein the first housing (14) comprises a wall (28) forming a chimney (30) surrounding the first terminal and the second terminal, the chimney (30) being suitable to receive a protective resin (29) so as to protect the electrical connection between the first busbar (8) and the first terminal (27) and the electrical connection between the second busbar (6) and the second terminal (28).

11. Electronic unit (1) for voltage converter (104) of rotating electrical machine (130) according to one of the previous claims wherein the first angle (7) has a value equal to 90°.

12. Voltage converter (104) of rotating electrical machine (130) comprising an electronic unit (1) for voltage converter (104) of rotating electrical machine (130) according to one of the previous claims and a power electronic module (110) suitable for electrically supplying a winding of rotating electrical machine (130).

13. Voltage converter (104) according to the previous claim wherein the first busbar (8) is a negative busbar and the second busbar (6) is a positive busbar.

14. Voltage converter (104) according to one of claims 12 to 13 wherein the power electronic module (110) comprises a third busbar (10) and a fourth busbar (21), the first busbar (8) being welded by a first laser weld with the third busbar (10) and the second busbar (6) being welded by a second laser weld with the fourth busbar (21).

15. Electrical assembly (100) comprising a voltage converter (104) according to one of claims 12 to 14 and a rotating electrical machine (130).
